# EUROPEAN PATENT SPECIFICATION

(11) **EP 1 614 216 B1**
(45) Date of publication and mention of the grant of the patent: **20.09.2006**
(21) Application number: 04721942.3
(22) Date of filing: 19.03.2004
(51) Int. Cl.: H03F 3/217, H02J 1/00, H04R 27/00, H04R 3/12

(54) **AMPLIFIER ARRANGEMENT AND DISTRIBUTED AUDIO SYSTEM**
VERSTÄRKEREINRICHTUNG UND DISTRIBUIERTES AUDIOSYSTEM
AGENCEMENT D'AMPLIFICATEUR ET SYSTEME AUDIO REPARTI

(30) Priority: 15.04.2003 GB 0308741
(43) Date of publication of application: 11.01.2006
(73) Proprietor: Armour Home Electronics Limited, Woking Surrey GU21 5SA (GB)
(72) Inventor: PRIVETT, Stephen, QED Audio Products Ltd, Woking, Surrey GU21 5JY (GB)
(74) Representative: Wood, Graham
(86) International application number: PCT/GB2004/001212
(87) International publication number: WO 2004/095690

(56) References cited:
- EP-A- 1 339 267
- WO-A-99/09787
- WO-A-02/061941
- WO-A-02/067403
- CA-A- 2 175 607
- US-A1- 2004 028 242
- SMITH K M ET AL: "Realization of a digital PWM power amplifier using noise and ripple shaping" POWER ELECTRONICS SPECIALISTS CONFERENCE, 1995. PESC '95 RECORD., 26TH ANNUAL IEEE ATLANTA, GA, USA 18-22 JUNE 1995, NEW YORK, NY, USA,IEEE, US, 18 June 1995 (1995-06-18), pages 96-102, XP010150544 ISBN: 0-7803-2730-6

## Description

The invention relates to a distributed audio system and amplifier arrangement therefor. A typical distributed audio system comprises of a centralised power supply powering an audio line driver and remote amplifiers within different zones.

To reduce system complexity it is desirable for the remote zone's power requirements to be supplied via a centralised supply. It is increasingly desirable to distribute power and signals for audio systems over standard small gauge signal conductors typically less than 26awg. Systems of this type suffer a number of problems; the centralised power supply needs to be of an undesirably high voltage and current capacity to overcome both power loss across the structured wiring cables and also losses at the 'remote' receiving amplifier associated with the line voltage regulation and amplification.

Typical structured wiring cables have a limited current capacity that severely restricts the audio level available at the remote location without the use of supplementary power supplies or larger gauge power conductors.

Systems of this type must be capable of operating over varying cable lengths dependent on the size of the installation. This leads to varying system performance and potential safety issues with excessive heat build up in confined spaces.

Traditional systems of this type suffer from excessive heat rise and severe thermal limiting of the audio output when the system is under load. This is a result of the amplifier being connected directly to a high supply voltage, necessary to overcome losses across the structured wiring cable.

The present invention seeks to provide distributed audio system, and an amplifier arrangement therefor, which reduces the problems associated power being supplied from remote source, e.g. located in a separate room.

According to a first aspect of the present invention there is provided an amplifier arrangement comprising an audio input, an audio output, a switching regulator and a switching amplifier, wherein the switching regulator is arranged to receive a variable DC electrical input from a power supply and output a substantially constant voltage to the switching amplifier. An amplifier arrangement of this nature is much less dependent upon the supply voltage as the regulator supplies the amplifier with a substantially constant supply regardless of the input into the regulator. In this way the power supply can be remote from the amplifier arrangement and so avoid the heat gain and other problems associated with an integrated power supply.

It is preferred for the switching amplifier to be a digital amplifier. The switching amplifier will often be in the form of a class D digital amplifier with associated H-bridge circuit on the output stage. These are very efficient amplifiers for use with audio amplification. Such digital amplification provides for much greater potential levels of audio amplification compared to e.g. analogue amplifiers.

In order to provide the best quality audio reproduction it will often be advantageous for the circuitry of either the switching regulator and/or the switching amplifier to constructed of discrete components rather than integrated circuits.

The switching amplifier will normally be configured to process at least two channels of audio input.

Often the amplifier arrangement will further include an auxiliary control device, e.g. to control the audio output volume or audio source e.g. CD, radio, TV, etc. This will generally be situated in the same room as the amplifier arrangement but may be short distance from the amplifier arrangement in order to be most convenient to the user.

Advantageously, the amplifier arrangement will have the switching regulator and the switching amplifier housed in a single housing. This housing will, of course, not contain the power supply and so operate without the high heat gain and/or other disadvantages associated with previously known installations.

According to a second aspect of the present invention, there is provided a distributed audio installation comprising the amplifier arrangement according to the first aspect of the invention and further including a remote power supply arranged to provide said variable DC electrical input. The distributed audio installation will normally have the power supply connectable to the amplifier arrangement via a cable which varies in length between a preselected maximum e.g. 50m, and a preselected minimum, e.g. 1m. Due to the amplifier arrangement, the distributed audio installation largely avoids the normal disadvantages associated with varying cable length.

The distributed audio system is particularly suitable for use with cables having less than 24awg (137 x 10⁻³ ohm/m).

The distributed audio system will often be configured so that the power supply is connected to a plurality of amplifier arrangements via respective electrical cables, for example in three, four or even more rooms.

Generally the invention comprises the use of a high efficiency electronic power supply regulator circuit coupled with the use of a high efficiency amplifier circuit used in a remotely powered amplifier system normally as part of a distributed audio installation.

The invention thus enables the use of a reduced capacity power supply, lowers power loss across small gauge structured wiring cables, reduces the heat dissipation of the receiving amplifier system and maintains audio performance over varying lengths of connecting cable. The invention can be viewed as the combined used of switching power supply and amplifier technology applied to the distribution of amplified audio signals across a structured wiring system using small gauge connecting cables system, to yield high system efficiency.

The use of such an approach ensures that audio performance is consistent across a range of cable lengths up to 50m using a centralised power supply. Amplifier system power output remains constant and is not limited by increased thermal dissipation in the audio amplifier due to an ever-increasing power supply voltage as the cable length decreases. At extended cable lengths the use of a high efficiency switching regulator and amplifier ensure that lower cable losses occur resulting in more power being available for a given power supply capacity.

This approach greatly reduces the supply demand on the power cable and increases available output power for the user. It also enables the amplifier system to operate more reliably in confined environments where heat dissipation is normally a problem.

The invention will now be described in relation to the accompanying drawings in which:
FIGURE 1 shows a typical distributed audio system and the location of the invention;
FIGURE 2 shows a block diagram of a preferred embodiment of the invention; and
FIGURE 3 shows a detailed circuit implementation of the embodiment of Figure 2.

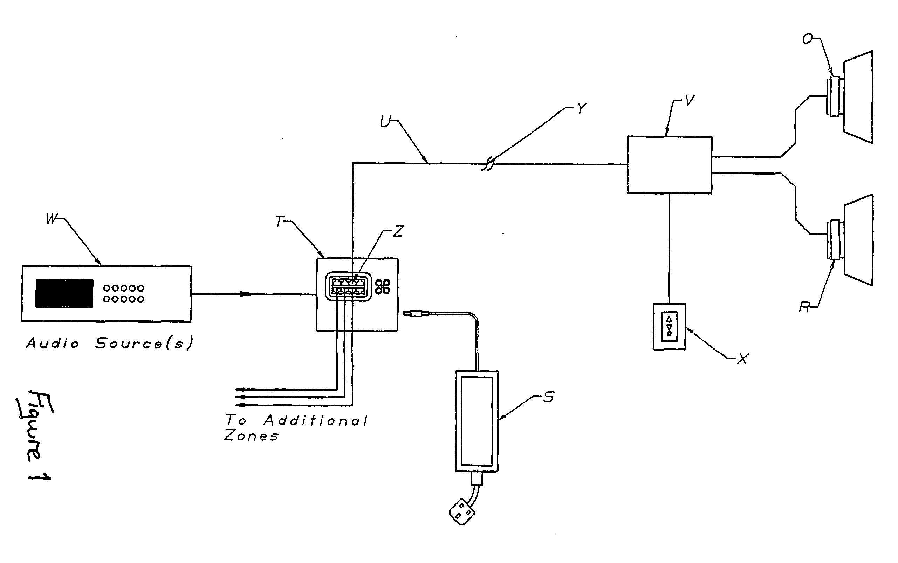

Figure 1 depicts a typical distributed audio system which embodies a preferred example of the invention. The audio source W, which may be one of a variety of audio sources, is fed into a distribution unit T for buffering and transmission. The power supply S supplies current through the connecting cable U to power the remote amplifier system V. Auxiliary control devices X may be connected to the remote amplifier system V as a means of control. The power for such devices is normally supplied by the remote supply S. The remote amplifier system utilising the invention is situated at point V and delivers high-level audio signals to the speakers Q, R.

The cable U is not a fixed length and therefore the impedance of the cable U will vary. Current flowing through the cable U will cause the voltage to drop across points Y, Z. The output voltage of the power supply S has to be high enough to ensure that there is sufficient voltage to operate the remote amplifier system V when the cable U is at its maximum specified length.

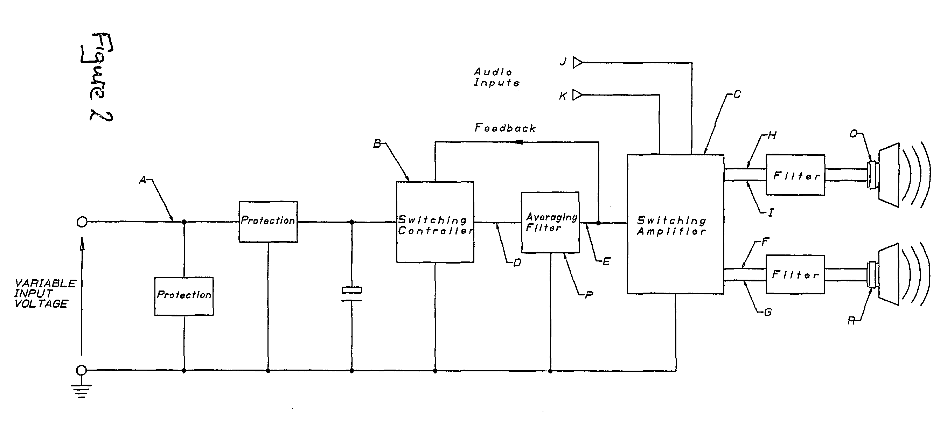

Figure 2 shows a block diagram showing the a preferred implementation of the amplifier arrangement according to the first aspect of the invention. The main elements are the switching controller B and the switching amplifier C. The variable DC supply voltage enters the system at point A and may vary between the maximum input voltage and minimum (drop out) voltage of the switching controller B. The switching controller steps down the supply voltage by 'chopping' the supply. The averaging filter P produces output voltage at E equal to the ON time of the output at point D divided by entire duty cycle period at point D and then multiplied by the supply input voltage at point A. The lower the DC input voltage at point A the longer the ON time at point D, the higher the input voltage the shorter the ON time at point D.

The averaged stepped down DC output at E is fed to the switching amplifier's power supply inputs. Audio inputs at points J, K are converted to differential PWM outputs at points H, G and respectively I, F. These are filtered to produce an audio signal voltage suitable for direct input to a loudspeaker system Q, R.

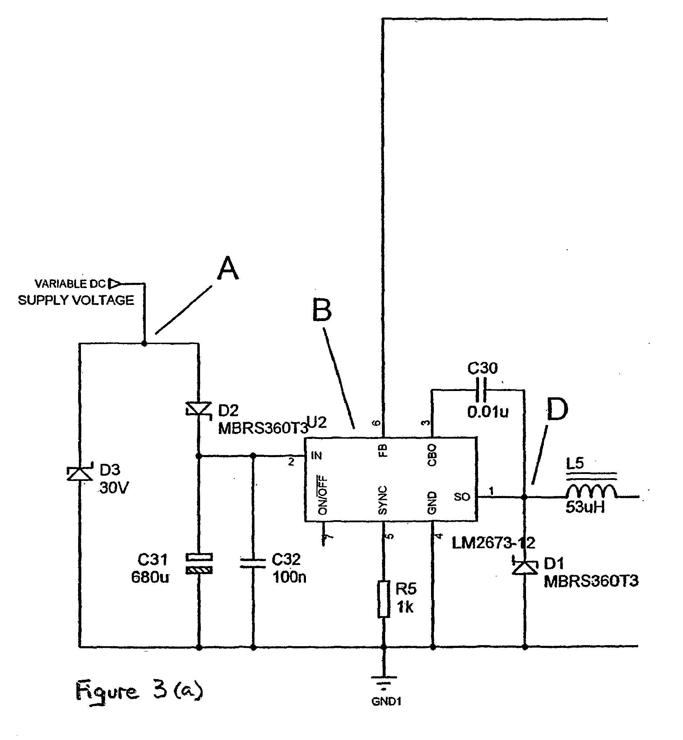

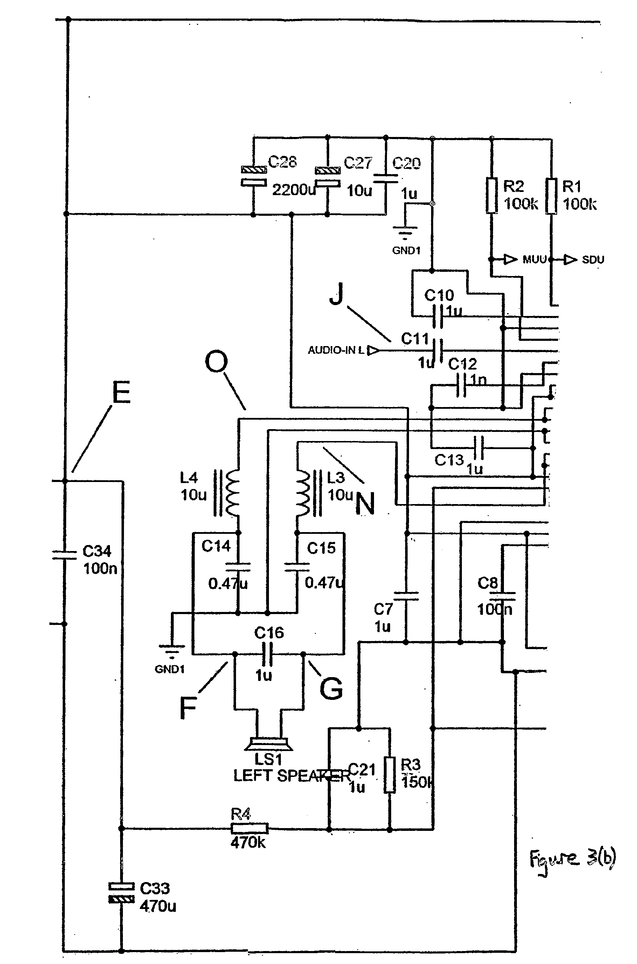

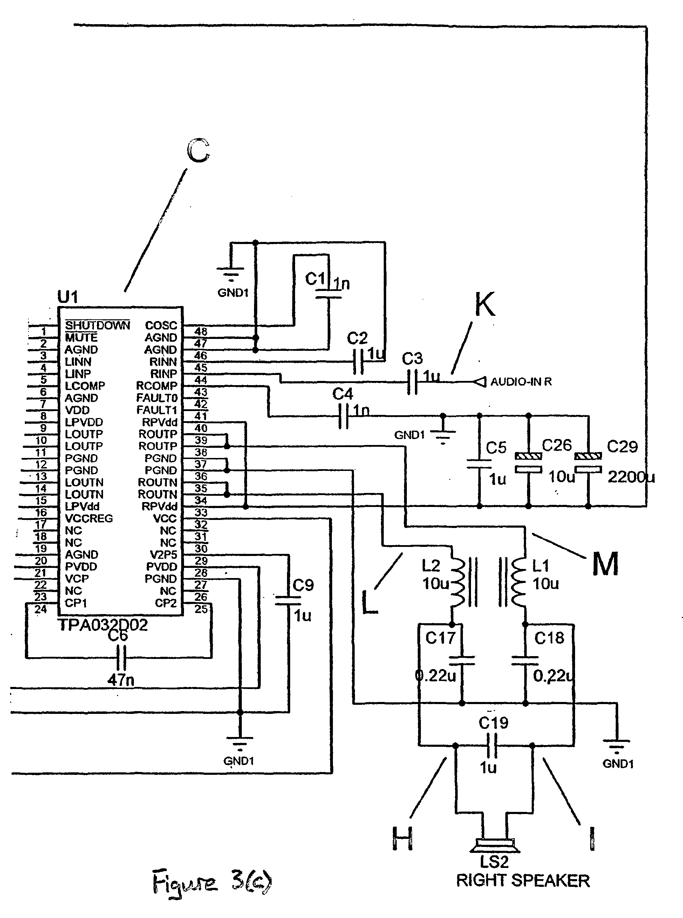

Figure 3 shows an electronic implementation of the invention, though alternatives will be readily apparent to the skilled person. The high efficiency audio system is configured around a high frequency switching amplifier C and switching step down voltage regulation circuit B. Power is supplied to the circuit at point A from a remote power supply Z. Over voltage protection for the switching supply is provided by a high-powered protection diode D3. Schottky Diode D2 protects against damage due to reverse polarity connection. Capacitors C31 and C32 provide filtering and charge storage. The voltage regulation circuit around U2 is a step down switching regulator operating at a frequency of 260kHz.

The efficiency of this regulation circuit is high (typically greater than 90%) because the output FET switching transistor is either ON or OFF producing a pulse width modulated charge current into the inductor L5 at point D, this causes the voltage across C33 to rise. Capacitor C30 connected at point D provides extra gate drive to the output switching FET transistor internal to U2 to ensure that it turns on fully. The output voltage appearing at point E is fed back to a reference circuit within U2 to determine when the output FET transistor within U2 should be turned OFF. At the FET transistor which is internal to U2 turn off point current circulates around the path formed by L5/C33 and the high-speed diode D1. This effectively transfers energy from the inductor L5 to C33 maintaining the output voltage at point E while the FET transistor which is internal to U2 is OFF.

The output voltage and current available at point E is used to feed the power supply inputs of the switching audio amplifier formed around U1. This is a Class D two-channel amplifier using ON/OFF FET switching transistors similar to the regulator circuit formed around U2. The FET transistors in both the Class D amplifier and Voltage regulation circuit are not operated in their linear region so power losses due to heat are very low, efficiency of the amplifier is typically >85%. The device U1 features an H-Bridge output stage, this arrangement enables a high output power to be achieved with a low supply voltage. This is a particularly preferred aspect of the invention since it enables the combined use of both a switching voltage regulator supply and switching audio amplifier to achieve high power output, and quality which is due to good line voltage regulation over varying supply cable impedances.

The amplifier U1 has two identical output circuits built around the filters formed by inductors L2/L1, L4/L3 and respectively capacitors C17/C18, C14/C15. These average the output currents of respectively L2/L1 & L4-/L3 with a voltage across the speaker LS2, LS1. The speakers connected at points H, I & F, G form the load of an H bridge driven by an inverted and non-inverted PWM output from U1. The bridge tied load configuration of the speaker results in an output differential voltage of 2x the supply voltage. The audio output voltage across the speakers LS1, LS2 are dependent on the output duty cycle at respectively points M, O and L, N multiplied by the supply voltage. If the duty cycle is 50:50 then there is no audio output. Capacitor C19, C16 provides additional low pass filtering of the switching frequency. An internal ramp oscillator within U1 switches the outputs at 250kHz. An audio signal present at point K, J is compared to a ramp oscillator voltage also internal to U1, if it is greater or less than zero the duty cycle is modulated and the differential PWM output at M, O and L, N results in an amplified audio output voltage across the speaker LS2, LS1.

It will be clear from the foregoing that the present invention generally relates to a remotely powered switching amplifier and power supply arrangement that reduces heat dissipation and increase the efficiency when powered over, particularly but not exclusively, small gauge structured wiring cables.

## Claims

1. An amplifier arrangement comprising an audio input (J,K), an audio output (F,G,H,I), a switching regulator (B) and a switching amplifier (C), wherein the switching regulator is arranged to receive a variable DC electrical input (A) from a power supply and output a substantially constant voltage to the switching amplifier, said power supply being arranged remotely of said amplifier arrangement.

2. The amplifier arrangement according to claim 1, wherein the switching amplifier is a digital amplifier.

3. The amplifier arrangement according to claim 1 or claim 2, wherein the switching amplifier is a class D digital amplifier with associated H-bridge circuit on the output stage.

4. The amplifier arrangement according to anyone of the preceding claims, wherein the circuitry of either the switching regulator and/or the switching amplifier is constructed of discrete components.

5. The amplifier arrangement according to anyone of the preceding claims, wherein the switching amplifier processes at lease two channels of audio input.

6. The amplifier arrangement according to anyone of the preceding claims, further including an auxiliary control device, e.g. to control the audio output volume.

7. The amplifier arrangement according to anyone of the preceding claims, wherein the switching regulator and the switching amplifier are housed in a single housing.

8. The distributed audio installation according to claim 1, wherein the power supply is connectable to the amplifier arrangement via a cable which varies in length between a preselected maximum e.g. 50m, and a preselected minimum, e.g. 1m.

9. The distributed audio system according to claim 9, wherein the cable is less than 24awg (137 x 10⁻³ ohm/m).

10. The distributed audio system according to claim 1, wherein the power supply is connectable to a plurality of amplifier arrangements via respective electrical cables.

## Patentansprüche

1. Verstärkeranordnung mit einem Audioeingang (J, K), einem Audioausgang (F, G, H, I), einem Schaltregler (B) und einem Schaltverstärker (C), wobei der Schaltregler die Aufgabe hat, einen variablen Gleichstromeingang (A) von einer Stromversorgung zu empfangen und eine im Wesentlichen konstante Spannung an den Schaltverstärker anzulegen, wobei sich die genannte Stromversorgung ortsfern von der genannten Verstärkeranordnung befindet.

2. Verstärkeranordnung nach Anspruch 1, wobei der Schaltverstärker ein Digitalverstärker ist.

3. Verstärkeranordnung nach Anspruch 1 oder Anspruch 2, wobei der Schaltverstärker ein Digitalverstärker der Klasse D mit assoziierter H-Brückenschaltung in der Ausgangsstufe ist.

4. Verstärkeranordnung nach einem der vorherigen Ansprüche, wobei der Schaltkomplex des Schaltreglers und/oder des Schaltverstärkers aus diskreten Komponenten konstruiert ist.

5. Verstärkeranordnung nach einem der vorherigen Ansprüche, wobei der Schaltverstärker wenigstens zwei Audioeingangskanäle verarbeitet.

6. Verstärkeranordnung nach einem der vorherigen Ansprüche, die ferner einen Zusatzregler z.B. zum Regeln der Ausgangstonlautstärke beinhaltet.

7. Verstärkeranordnung nach einem der vorherigen Ansprüche, wobei der Schaltregler und der Schaltverstärker in einem einzigen Gehäuse untergebracht sind.

8. Verteilte Tonanlage nach Anspruch 1, wobei die Stromversorgung über ein Kabel, dessen Länge zwischen einem vorgewählten Maximum von beispielsweise 50 m und einem vorgewählten Minimum von beispielsweise 1 m variiert, an der Verstärkeranordnung angeschlossen werden kann.

9. Verteilte Tonanlage nach Anspruch 8, wobei die Kabelstärke geringer als 24 AWG (137 x 10⁻³ Ohm/m) ist.

10. Verteilte Tonanlage nach Anspruch 1, wobei die Stromversorgung über jeweilige Stromkabel an mehrere Verstärkeranordnungen angeschlossen werden kann.

## Revendications

1. Agencement d'amplificateur comprenant une entrée audio (J, K), une sortie audio (F, G, H, I), un régulateur de commutation (B) et un amplificateur de commutation (C), dans lequel le régulateur de commutation est agencé de façon à recevoir une entrée électrique variable c.c. (A) à partir d'une alimentation d'énergie électrique et à délivrer une tension sensiblement constante à l'amplificateur de commutation, ladite alimentation d'énergie électrique étant disposée à distance dudit agencement d'amplificateur.

2. Agencement d'amplificateur, selon la revendication 1, dans lequel l'amplificateur de commutation est un amplificateur numérique.

3. Agencement d'amplificateur, selon la revendication 1 ou la revendication 2, dans lequel l'amplificateur de commutation est un amplificateur numérique de classe D alors qu'un circuit pont en H lui est associé sur l'étage de sortie.

4. Agencement d'amplificateur, selon l'une quelconque des revendications précédentes, dans lequel les circuits de l'un des postes suivants, à savoir le régulateur de commutation et/ou l'amplificateur de commutation, est construit avec des composants discrets.

5. Agencement d'amplificateur, selon l'une quelconque des revendications précédentes, dans lequel l'amplificateur de commutation effectue le traitement d'au moins deux canaux de l'entrée audio.

6. Agencement d'amplificateur, selon l'une quelconque des revendications précédentes, comprenant en outre un dispositif de commande auxiliaire, afin de gérer le volume de sortie audio par exemple.

7. Agencement d'amplificateur, selon l'une quelconque des revendications précédentes, dans lequel le régulateur de commutation et l'amplificateur de commutation sont logés dans un seul boîtier.

8. Installation audio répartie, selon la revendication 1, dans laquelle l'alimentation d'énergie électrique peut être connectée à l'agencement d'amplificateur par l'intermédiaire d'un câble dont la longueur varie entre une longueur maximum présélectionnée, par exemple 50 m, et une longueur minimum présélectionnée, par exemple 1 m.

9. Système audio réparti, selon la revendication 8, dans lequel le câble est inférieur à 24 AWG (137 x 10⁻³ ohm/m).

10. Système audio réparti, selon la revendication 1, dans lequel l'alimentation d'énergie électrique peut être connectée à une pluralité d'agencements d'amplificateur par l'intermédiaire de câbles électriques respectifs.
